# EUROPÄISCHE PATENTANMELDUNG

(11) **EP 1 174 932 A2**
(43) Veröffentlichungstag der Anmeldung: **23.01.2002**
(21) Anmeldenummer: 01440115.2
(22) Anmeldetag: 20.04.2001
(51) Int. Cl.: H01L 33/00

(54) **Subträger, elektronische Baugruppe und Verfahren zur Herstellung derselben**

(30) Priorität: 19.07.2000 DE 10035399
(71) Anmelder: ALCATEL, 75008 Paris (FR)
(72) Erfinder: Ferling, Dieter, 70199 Stuttgart (DE); Gutu-Nelle, Anca, 70439 Stuttgart (DE)
(74) Vertreter: Brose, Gerhard, Dipl.-Ing.

(57) **Zusammenfassung**

Elektronische Bauelemente, insbesondere opto-elektronische Bauelemente werden üblicherweise auf einen Subträger (Englisch: submount) aufgebracht, auf dessen Oberfläche sich Kontaktflächen für die elektrische Kontaktierung der Bauelemente befinden. Es kann ein sogenanntes Übersprechen (Englisch: cross talk) zwischen zwei Bauelementen auftreten. Dieser Störeffekt reduziert deutlich den Signal-Interferenz-Verhältnis der Nachrichtensignale und damit die Leistungsfähigkeit der Baugruppe.

Vorgeschlagen wird hier, in den Subträger (1) zumindest unterhalb der Stelle, an der sich die erste Kontaktfläche (5) befindet, eine Vertiefung (8) einzubringen, die mit einer Metallschicht (6a) versehen und mit einem Dielektrikum verfüllt ist, wobei die Metallschicht (6a) mit der zweiten, gegenpoligen Kontaktfläche (6) elektrisch verbunden ist. Damit werden die Feldlinien in der mit dem Dielektrikum aufgefüllten Vertiefung konzentriert, wobei die dort aufgetragene Metallschicht das Material des Subträgers gegen ein Eindringen der Feldlinien abschirmt. Die Schaffung einer Vertiefung hat den Vorteil, dass die Bauhöhe der neuen Anordnung im Vergleich zu einer herkömmlichen Anordnung erhalten bleibt.

## Beschreibung

Die Erfindung betrifft einen Subträger für elektronische Bauelemente nach dem Oberbegriff des Anspruchs 1. Außerdem betrifft die Erfindung eine Baugruppe mit mindestens einem solchen Bauelement und ein Verfahren zur Herstellung einer solchen Baugruppe nach einem der nebengeordneten Ansprüche.

Elektronische Bauelemente (Englisch: components), insbesondere opto-elektronische Bauelemente werden üblicherweise auf einen Subträger (Englisch: submount) aufgebracht, der beispielsweise aus Silizium oder aus Keramikmaterial besteht. Auf der der Oberfläche des Subträgers befinden sich Kontaktflächen für die elektrische Kontaktierung der Bauelemente. Das Kontaktieren erfolgt üblicherweise durch sogenanntes Bonding, ein Verfahren, bei dem die Kontakte auf der Oberseite der Bauelemente mit den Kontaktflächen des Subträgers über feine Golddrähte miteinander verbunden werden. Die auf der Unterseite der Bauelemente befindlichen Kontakte werden nach dem sogenannten Flip-Chip-Verfahren mit den Kontaktflächen verbunden. Zur richtigen Positionierung der Bauelemente sind üblicherweise Sockelflächen vorgesehen, die häufig aus Glasmaterial bestehen, das auch zur Herstellung von Lichtwellenleitern verwendet wird. Diese Technologie wird häufig im Bereich der optischen Nachrichtenübertragung eingesetzt, bei der durch Laser erzeugtes Licht moduliert und übertragen wird. Die aus einem oder auch mehreren Bauelemneten bestehenden Baugruppen müssen sehr leistungsfähig sein, besonders im Bereich der optischen Nachrichtentechnik benötigt, wo sehr kurze Schaltzeiten von weniger als 200 Pikosekunden und entsprechend hohe Datenübertragungsraten von bis zu 10 Gbit/s erreicht werden sollen. Die verwendeteten Bauelemente sind beispielsweise opto-elektronische Schaltkreise, die als optischer Sender oder Verstärker ausgeführt sind. Bei der Anordnung von mehreren Bauelementen auf einem Subträger kann sogenanntes Übersprechen (Englisch: cross talk) zwischen direkt zueinander benachbarten Bauelementen auftreten. Dieser Störeffekt reduziert deutlich den Signal-Interferenz-Verhältnis der Nachrichtensignale und damit die Leistungsfähigkeit der Baugruppe.

Aus der DE-A-19522591 ist eine Baugruppe mit einem Subträger und mit darauf angeordneten opto-elektronischen Bauelementen bekannt. Zu den dort beschriebenen Bauteilen zählen u.a. ein optischer Koppler, eine damit verbundene emittierende Lichtquelle und Lichtsignaldetektoren. Um das zwischen der Lichtquelle und den Lichtdetektoren auftretende elektrische Übersprechen zu reduzieren, werden dort die Lichtquelle einerseits und die Lichtdetektoren andererseits auf sich gegenüberliegenden Seiten des Kopplers angeordnet. Damit werden also die sich störenden Bauelemente weit weg voneinander angeordnet, um eine möglichst große räumliche Trennung zu erzielen. Diese Maßnahme kann aber nicht immer durchgeführt werden, insbesondere nicht bei hoch-integrierten Baugruppen. Außerdem steht diese Maßnahme dem Wunsch entgegen, die Platzierung der Bauelemente auf dem Subträger möglichst frei gestalten zu können.

Aufgabe der Erfindung ist es, einen Subträger für elektronische Bauelemente zu schaffen, bei dem die oben genannten Probleme nicht auftreten. Außerdem sollen eine Baugruppe mit einem solchen Subträger und ein Verfahren zur Herstellung einer solchen Baugruppe vorgeschlagen werden.

Gelöst wird die Aufgabe durch einen Subträger mit den Merkmalen nach Anspruch 1 sowie durch eine Baugruppe und ein Verfahren mit den Merkmalen nach einem der nebengeordneten Ansprüche.

Demnach wird ein Subträger für elektronische Bauelemente vorgeschlagen, der eine Oberfläche hat, auf der eine erste Kontaktfläche und eine zweite, gegenpolige Kontaktfläche zum elektrischen Kontaktieren eines der elektronischen Bauelemente aufgebracht sind, und der zumindest unterhalb der Stelle, an der sich die erste Kontaktfläche befindet, eine Vertiefung hat, die mit einer Metallschicht versehen und mit einem Dielektrikum verfüllt ist, wobei die Metallschicht mit der zweiten Kontaktfläche elektrisch verbunden ist.

Dementsprechend hat die erfindungsgemäße Baugruppe mindestens ein elektrisches Bauelement und einen Subträger mit einer Oberfläche, auf der eine erste Kontaktfläche und eine zweite Kontaktfläche zum elektrischen Kontaktieren des elektronischen Bauelements aufgebracht sind. Und die Baugruppe ist dadurch gekennzeichnet, dass der Subträger zumindest unterhalb der Stelle, an der sich die erste Kontaktfläche befindet, eine Vertiefung hat, die mit einer Metallschicht versehen und mit einem Dielektrikum verfüllt ist, und dass die Metallschicht mit der zweiten Kontaktfläche elektrisch verbunden ist. Zur Herstellung der Baugruppe wird also erfindungsgemäß in den Subträger zumindest unterhalb der Stelle, an der sich die erste Kontaktfläche befindet, eine Vertiefung eingebracht, wobei die Vertiefung mit einer Metallschicht versehen und mit einem Dielektrikum verfüllt wird, und wobei die Metallschicht mit der zweiten Kontaktfläche elektrisch verbunden wird.

Die Erfindung geht von der Erkenntnis aus, dass bei einem herkömmlichen Subträger das störende Übersprechen im wesentlichen durch auftretende Feldlinien hervorgerufen wird, die zwischen den gegenpoligen Kontaktflächen verlaufen, wobei sie zum großen Teil in das Material des Subträgers eindringen und sich von dem Bereich eines Bauelements zu den Bereichen der benachbarten Bauelemente und darüber hinaus fortpflanzen. Durch die erfindungsgemäßen Maßnahmen jedoch werden die Feldlinien in der mit dem Dielektrikum aufgefüllten Vertiefung konzentriert, wobei die dort aufgetragene Metallschicht das Material des Subträgers gegen ein Eindringen der Feldlinien abschirmt. Es wird also ein durch die Abmessungen der Vertiefung definierter Bereich zwischen der ersten Kontaktfläche und der mit der zweiten Kontaktfläche verbundenen Metallfläche (Gegenpol) geschaffen, in welchem der Großteil der Feldlinien eingefangen wird. Die Schaffung einer Vertiefung hat den Vorteil, dass die Bauhöhe der neuen Anordnung im Vergleich zu einer herkömmlichen Anordnung erhalten bleibt. Außerdem kann das Beschichten der Vertiefung mit Metall und das anschließende Verfüllen mit einem Dielektrikum sehr genau mit einem an sich bekannten Dünnschicht-Verfahren durchgeführt werden. Die Erfindung, die einfach zu realisieren ist, sowie die sich aus der Erfindung ergebenden Vorteile werden später noch eingehend beschrieben.

### Besondere Vorteile der Erfindung ergeben sich aus den Unteransprüchen:

Es ist demnach besonders vorteilhaft, wenn die Vertiefung mit einem Polymer verfüllt ist bis zu einer Höhe, die mit der Oberfläche des Subträgers abschließt. Denn das Polymer kann schon bei einer Erwärmung von z.B. 400° C, d.h. bei einer Temperatur weit unterhalb der Schmelztemperatur von Glas oder Metall, sehr leicht verarbeitet und in die Vertiefung eingebracht werden. Auch die Füllhöhe kann exakt an das Niveau der Subträgeroberfläche angepaßt werden, wodurch die ursprüngliche Bauhöhe der Gesamtanordnung erhalten bleibt.

Es ist vorteilhaft, wenn die Metallschicht und das Dielektrikum in Dünnschicht-Technologie aufgebaut sind. Damit kann eine sehr genaue Geometrie der Anordnung eingehalten werden.

Vorzugsweise besteht der Subträger aus Silizium und das Bauelement ist ein opto-elektronisches Bauelement. Außerdem ist es vorteilhaft, wenn die erste Kontaktfläche zusammen mit mindestens zwei Sockelflächen das Bauelement mit dem Subträger entsprechend der Flip-Chip-Technik verbinden. Dadurch wird eine sehr schnelle und passgenaue Positionierung sowie Kontaktierung des Bauelements erreicht. In diesem Zusammenhang ist es besonders von Vorteil, wenn die Sockelflächen aus einem Glasmaterial bestehen.

Im folgenden wird die Erfindung genau beschrieben anhand eines Ausführungsbeispiels und unter Zuhilfenahme der folgenden Zeichnungen:
- Fig. 1,: die schematisch den Aufbau eines herkömmlichen Subträgers im Querschnitt zeigt;
- Fig. 2,: die den Aufbau eines erfindungsgemäßen Subträgers im Querschnitt zeigt; und
- Fig. 3,: die den Aufbau des erfindungsgemäßen Subträgers in der Draufsicht zeigt.

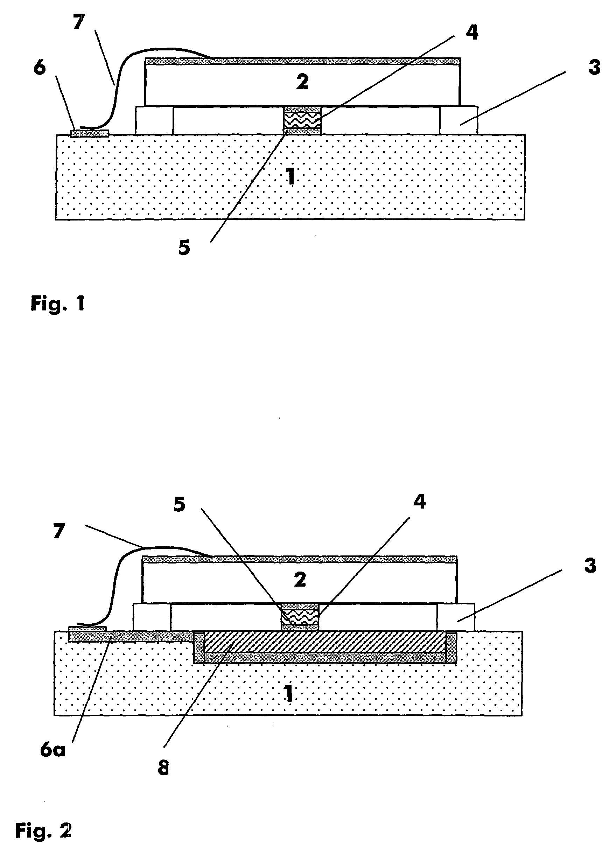

Die Fig. 1 zeigt im Querschnitt den Aufbau eines herkömmlichen Subträgers 1, auf dem ein Bauelement 2 aufgebracht ist. Der Subträger (engl.: submount), der auch Schaltungsträger genannt wird, besteht aus Silizium und hat auf seiner Oberfläche Kontaktflächen zum elektrischen Kontaktieren des Bauelementes 2, nämlich eine erste Kontaktfläche 5 und eine zweite, gegenpolige Kontaktfläche 6. Über diese Kontaktflächen, die z.B. aus Gold bestehen, wird das Bauelement 2 mit Spannung versorgt. Das Bauelement 2 ist entsprechend der sogenannten Flip-Chip-Technik über eine Lötmasse 4 mit der ersten Kontaktfläche 5 verbunden. Mit der zweiten Kontaktfläche 6 ist das Bauelement 2 über einen Bondingdraht 7 verbunden. Zur genauen Positionierung des Bauelementes hat der Subträger 1 zwei Sockelflächen 3, die aus Glasmaterial bestehen und auf denen das Bauelement aufliegt. Die Sockelflächen bestehen aus Siliziumoxid (SiO₂), einem bewährten Lichtwellenleitermaterial, und haben eine Höhe von etwa 20 µm. Durch die Geometrie der Sockelflächen und über die Flip-Chip-Kontaktierung ist das Bauelement 2 auf dem Subträger 1 genau positioniert und fixiert.

Entsprechend der Fig. 1 werden üblicherweise opto-elektronische Schaltungen, wie zum Beispiel Verstärker oder Laser-Dioden-Sender, auf einem Subträger aufgebracht und kontaktiert. Das Problem bei der dargestellten herkömmlichen Anordnung ist, dass sich elektrische Feldlinien von der einen Kontaktfläche zu der gegenpoligen Kontaktfläche ausbreiten und das Subträgermaterial durchdringen, wobei sich die Feldlinien von diesem Bereich ablösen und sich in die Bereiche der anderen Bauelementen ausbreiten können. Dadurch können sich zwei Bauelemente (Schaltungen) gegenseitig in ihrem Betrieb stören. Diese Art von Störung wird auch Übersprechen (engl.: crosstalk) genannt und führt zu einer Reduzierung des Signal-Interferenz-Verhältnis.

Die Fig. 2 zeigt nun ein Ausführungsbeispiel der Erfindung, bei dem diese Probleme nicht auftreten. Im Vergleich zu Fig. 1 hat der in Fig. 2 dargestellte Subträger 1 eine Vertiefung 8 unterhalb der Stelle, an der sich die erste Kontakfläche 5 befindet. Die Wandung der Vertiefung 8 ist mit einer aus Gold bestehenden Metallschicht 6a versehen, die elektrisch mit der zweiten, gegenpoligen Kontaktfläche 6 verbunden ist. Außerdem ist die Vertiefung 8 mit einem Polymer, das als Dielektrikum dient, verfüllt worden. Die sich von der ersten Kontraktfläche 5 ausbreitenden elektrischen Feldlinien werden in dem Dielektrikum konzentriert und durch die Metallschicht 6a abgefangen. Somit können die elektrischen Feldlinien das Subträgermaterial nicht durchdringen. Eine Ausbreitung von Feldlinien in den Bereich von benachbarten Bauelementen oder darüber hinaus und ein daraus resultierendes Übersprechen werden somit deutlich reduziert. Messungen haben ergeben, dass bei der erfindunggemäße Baugruppe ein um etwa 40dB geringeres Übersprechen auftritt, als bei einer herkömmlichen Baugruppe.

Durch die Schaffung der Vertiefung 8 ist es möglich, die Bauhöhe der Gesamtanordnung beizubehalten und weiterhin die Flip-Chip-Technik zur optimalen Positionierung und Kontaktierung des Bauelementes 2 beizuhalten. Dazu wird die Vertiefung mit dem Polymer exakt bis zum Rand verfüllt, das heißt, die Füllhöhe der Vertiefung 8 schließt mit der Oberflächer des Subträgers 1 ab.

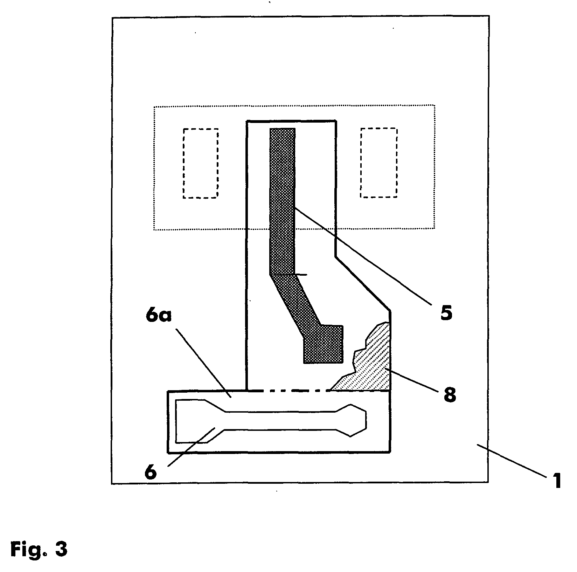

Die Fig. 3 zeigt in der Draufsicht die erfindungsgemäße Anordnung und besonders den Verlauf der Kontaktflächen 5 und 6 sowie die Geometrie der mit dem Polymer verfüllten Vertiefung 8. Die erste Kontaktfläche 5 verläuft quer zur Ausrichtung des Bauelementes 2 zwischen den beiden Sockeln und endet in einem im äußeren Randbereich des Bauelementes 2 angeordneten Kontaktpunkt. Dieser Kontaktpunkt dient zum Anschluss an einen Pol (hier der Pluspol) der Stromversorgung. Die zweite, gegenpolige Kontaktfläche 6 ist ein außerhalb des Randbereiches des Bauelementes 2 in Längrichtung aufgebrachter Metallstreifen mit zwei an seinen Enden angeordneten Kontaktpunkten. Der eine Kontaktpunkt dient zur Fixierung des Bondingdrahtes, der andere Kontaktpunkt dient zum Anschluss des Gegenpols (hier der Minuspol) der Stromversorgung.

Die in dem Subträger 1 eingebrachte Vertiefung 8 beginnt unterhalb des Bauelementes 2 und erstreckt sich über den Randbereich des Bauelementes 2 hin zu der zweiten Kontaktfläche 6. Dabei umfasst die Vertiefung 8 im Wesentlichen die Bereiche unterhalb der ersten Kontaktfläche 5. Die Vertiefung ist wannenförmig ausgebildet und mit einer aus Gold bestehenden Metallschicht 6a bedampft; die Metallschicht erstreckt sich über die Vertiefung 8 hinaus bis in den Bereich der zweiten Kontaktfläche 6. Dort ist die Metallschicht 6a mit dieser zweiten Kontaktfläche 6 elektrisch verbunden. Dadurch wirkt die Metallschicht 6a wie eine Abschirmung, die die elektrischen Feldlinien auffängt, welche von der ersten Kontaktfläche 5 austreten. Durch das Auffüllen der Vertiefung 8 mit einem Polymer werden die elektrischen Feldlinien in diesem Polymer konzentriert, wodurch der überwiegende Anteil der elektrischen Feldlinien innerhalb der Vertiefung 8 verbleibt. Die Feldliniendichte außerhalb der Vertiefung 8, insbesondere auf der Subträger-Oberfläche, ist vernachlässigbar gering. Die Vertiefung 8 wirkt demnach wie ein Potentialtopf, in dem die Feldlinien verbleiben. Durch diese lokale Abschirmung der Feldlinien wird ein Übersprechen auf benachbarte Bauelemente vermieden. Auf dem in den Fig. 2 und 3 dargestellten Subträger 1 sind neben dem dargestellten Bauelement 2 auch weitere hier nicht dargestellte Bauelemente aufgebracht. Die aus dem Subträger 1 und aus mehreren Bauelementen bestehende Anordnung bildet eine Baugruppe. Um ein Übersprechen zwischen den Bauelementen zu verhindern, reicht es aus, wenn im Wesentlichen für jedes zweite Bauelement eine Vertiefung vorgesehen wird. Auch ist es denkbar, nur diejenigen Bereiche mit Vertiefungen zu versehen, an denen sich störempfindliche Bauelemente, wie z.B. Detektorschaltungen, befinden. Bei anderen, weniger störempfindlichen Schaltungen, insbesondere bei Schaltungen, die viel Wärme produzieren, wie etwa starke Laser, kann man auf die Vertiefung verzichten. In diesen speziellen Fällen würde eine mit Polymer aufgefüllte Vertiefung der Wärmeabfuhr hinderlich sein. Es ist jedoch in den meisten Fällen vorteilhaft, wenn für jedes Bauteil eine solche Vertiefung in den Subträger eingelassen wird. Das Verfahren zur Herstellung der erfindungsgemäßen Vertiefung kann mittels einer Dünnschicht-Technologie wie folgt erfolgen:

Zunächst wird in den planaren Subträger 1 die Vertiefung 8 mittels Fräsen oder Ätzen eingebracht. Danach wird die Wandung der Vertiefung mit Gold bedampft, um die beschriebene Metallschicht 6a zu bilden. Die Metallschicht verläuft bis in den Bereich der zweiten, gegenpoligen Kontaktfläche 6. Die Vertiefung 8 selbst wird mit einem Polymer verfüllt bis zur Höhe der Oberfläche des Subträgers 1. Durch Lithographie kann eine seitliche Begrenzung des Polymermaterials erzielt werden. An der für die Kontaktfläche 5 vorgesehenen Stelle wird das Polymer exakt verfüllt, um eine genaue Bauhöhe zu erreichen. Die erste Kontaktfläche 5 wird dann auf dem Polymer angebracht. Diese Kontaktfläche sowie die Sockelflächen dienen zum Kontaktieren und Fixieren des Bauelementes 2 in der an sich bekannten Flip-Chip-Technik.

Bei der beschriebenen Erfindung wurde die Vertiefung in dem Subträger mit einer Metallschicht versehen, die eine elektrische Abschirmung bewirkt. Es ist jedoch auch denkbar, eine Vertiefung ohne eine Metallschicht zu versehen und diese Vertiefung lediglich mit einem Dielektrikum zu verfüllen. Sofern das kapazitive Verhalten des Bauelementes beim Betrieb zu beachten ist, hätte diese Anordnung den Vorteil, dass die mit dem Dielektrikum verfüllte Vertiefung als parasitäre Kapazität wirken würde, die parallel zur Kapazität des Bauelementes geschaltet wäre. Da das Polymer im Vergleich zum Silizium (εᵣ =12) einen relativ geringen Dielektrizitätswert von etwa εᵣ = 3 bis 4 hat, wird die Gesamtkapazität der Anordnung kleiner und damit wird die Grenzfrequenz erhöht. Auf diese Weise wird mit einfachen Mitteln das Betriebsverhalten der Baugruppe verbessert. Diese Anordnung, bei der lediglich eine Vertiefung mit einem Dielektrikum vorgesehen ist, stellt somit eine eigenständige Lösung dar für das Problem des kapazitiven Verhaltens der Baugruppe.

## Patentansprüche

1. Subträger (1) für elektronische Bauelemente mit einer Oberfläche, auf der eine erste Kontaktfläche (5) und eine zweite, gegenpolige Kontaktfläche (6) zum elektrischen Kontaktieren eines (2) der elektronischen Bauelemente aufgebracht sind,
**dadurch gekennzeichnet, dass**
der Subträger (1) zumindest unterhalb der Stelle, an der sich die erste Kontaktfläche (5) befindet, eine Vertiefung (8) hat, die mit einer Metallschicht (6a) versehen und mit einem Dielektrikum verfüllt ist, und dass die Metallschicht (6a) mit der zweiten Kontaktfläche (6) elektrisch verbunden ist.

2. Subträger (1) nach Anspruch 1, **dadurch gekennzeichnet, dass**
die Vertiefung (8) mit einem Polymer verfüllt ist bis zu einer Höhe, die mit der Oberfläche des Subträgers (1) abschließt.

3. Subträger (1) nach Anspruch 1, **dadurch gekennzeichnet, dass**
der Subträger (1) aus Silizium besteht und dass das Bauelement ein opto-elektronisches Bauelement (2) ist.

4. Subträger (1) nach Anspruch 1, **dadurch gekennzeichnet, dass** die Metallschicht (6a) und das Dielektrikum in Dünnschicht-Technologie aufgebaut sind.

5. Subträger (1) nach Anspruch 1, **dadurch gekennzeichnet, dass** die erste Kontaktfläche (5) zusammen mit mindestens zwei Sockelflächen (3) das Bauelement (2) mit dem Subträger (1) entsprechend der Flip-Chip-Technik verbinden.

6. Subträger (1) nach Anspruch 5, **dadurch gekennzeichnet, dass** die Sockelflächen (3) aus einem Glasmaterial bestehen.

7. Elektronische Baugruppe mit mindestens einem elektrischen Bauelement (2) und mit einem Subträger (1), der eine Oberfläche hat, auf der eine erste Kontaktfläche (5) und eine zweite, gegenpolige Kontaktfläche (6) zum elektrischen Kontaktieren des elektronischen Bauelements (2) aufgebracht sind,
**dadurch gekennzeichnet, dass**
der Subträger (1) zumindest unterhalb der Stelle, an der sich die erste Kontaktfläche (5) befindet, eine Vertiefung (8) hat, die mit einer Metallschicht (6a) versehen und mit einem Dielektrikum verfüllt ist, und dass die Metallschicht (6a) mit der zweiten Kontaktfläche (6) elektrisch verbunden ist.

8. Verfahren zum Herstellen einer elektronischen Baugruppe, bei dem auf die Oberfläche eines Subträgers (1) eine erste Kontaktfläche (5) und eine zweite, gegenpolige Kontaktfläche (6) aufgebracht werden und bei dem zumindest ein elektronisches Bauelement (2) mittels der Kontaktflächen (5, 6) kontaktiert wird,
**dadurch gekennzeichnet, dass** in den Subträger (1) zumindest unterhalb der Stelle, an der sich die erste Kontaktfläche (5) befindet, eine Vertiefung (8) eingebracht wird, dass die Vertiefung mit einer Metallschicht (6a) versehen und mit einem Dielektrikum verfüllt wird, und dass die Metallschicht (6a) mit der zweiten Kontaktfläche (6) elektrisch verbunden wird.
